(19) Europäisches Patentamt / European Patent Office / Office européen des brevets

(11) **EP 3 425 486 A1**

(12) **EUROPEAN PATENT APPLICATION**
published in accordance with Art. 153(4) EPC

(43) Date of publication:
**09.01.2019 Bulletin 2019/02**

(51) Int Cl.:
*G06F 3/02* (2006.01)    *H01G 9/20* (2006.01)

(21) Application number: **17759800.0**

(22) Date of filing: **23.02.2017**

(86) International application number:
**PCT/JP2017/006836**

(87) International publication number:
**WO 2017/150334 (08.09.2017 Gazette 2017/36)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **04.03.2016 JP 2016042895**

(71) Applicant: **Fujikura Ltd.
Tokyo 135-8512 (JP)**

(72) Inventor: **ENDOH Katsuyoshi
Sakura-shi
Chiba 285-8550 (JP)**

(74) Representative: **Hoffmann Eitle
Patent- und Rechtsanwälte PartmbB
Arabellastraße 30
81925 München (DE)**

(54) **INPUT DEVICE**

(57)    Disclosed is an input device including: at least one photoelectric conversion cell; and a touch sensor which faces the at least one photoelectric conversion cell, and includes a substrate, a display unit being visible in the case of viewing the touch sensor and the photoelectric conversion cell in a thickness direction of the substrate of the touch sensor. The photoelectric conversion cell includes a transparent electrode substrate provided on the touch sensor side, a counter substrate which is provided on a side facing away from the touch sensor, with respect to the transparent electrode substrate, and faces the transparent electrode substrate, a power generation portion which is provided between the transparent electrode substrate and the counter substrate, and contains a dye, and a non-power generation portion provided to be adjacent to the power generation portion and to overlap with the display unit in the case of viewing the power generation portion and the display unit in the thickness direction of the substrate of the touch sensor.

Fig.4

Printed by Jouve, 75001 PARIS (FR)

**Description**

TECHNICAL FIELD

The present invention relates to an input device including a touch sensor.

BACKGROUND ART

A photoelectric conversion element such as a dye-sensitized solar cell or an organic thin film solar cell is expected as a power source of various devices. In many cases, the photoelectric conversion element is typically used only as a cell, but recently, a case has also increased in which the photoelectric conversion element is included in an input device including a touch sensor, as a power source of the input device.

For example, in Patent Document 1 described below, an input device including a dye-sensitized solar cell, and a touch sensor facing the dye-sensitized solar cell, is disclosed. In this publication, it is also disclosed that the dye-sensitized solar cell includes a transparent electrode substrate provided on a side facing the touch sensor, a counter substrate which is provided on a side facing away from the touch sensor, with respect to the transparent electrode substrate, and faces the transparent electrode substrate, and a porous semiconductor layer provided between the transparent electrode substrate and the counter substrate.

CITATION LIST

PATENT DOCUMENT

Patent Document 1: JP 2013-89527 A

SUMMARY OF THE INVENTION

PROBLEM TO BE SOLVED BY THE INVENTION

However, the input device described in Patent Document 1 described above, has had the following problems.

That is, the input device described in Patent Document 1, has room for improvement in durability.

The invention has been made in consideration of the circumstances described above, and an object thereof is to provide an input device capable of improving durability.

MEANS FOR SOLVING PROBLEM

As a result of studying the reason of the problems described above, the present inventors have considered as follows. That is, first, the touch sensor, for example, typically includes a display unit such as "1" and "2", and the display unit overlaps with a porous semiconductor layer of a dye-sensitized solar cell in the case of viewing the display unit in a thickness direction of a substrate constituting the touch sensor. Here, when light incident from the touch sensor is incident on the dye-sensitized solar cell, the porous semiconductor layer is divided into a portion which becomes a shadow of the display unit, and a portion on which light is incident without being a shadow. The present inventors have considered that a bias is generated at this time in a generation amount of electrons between the portion which becomes the shadow and the portion which does not become the shadow, and as a result, a dye deteriorates, and thus, power generation performance is degraded. Therefore, as a result of conducting intensive studies, the present inventors have completed the invention.

That is, the invention is an input device including: at least one photoelectric conversion cell; and a touch sensor which faces the at least one photoelectric conversion cell, and includes a substrate, a display unit being visible in the case of viewing the touch sensor and the photoelectric conversion cell in a thickness direction of the substrate of the touch sensor, in which the photoelectric conversion cell includes, a transparent electrode substrate provided on the touch sensor side, a counter substrate which is provided on a side facing away from the touch sensor, with respect to the transparent electrode substrate, and faces the transparent electrode substrate, a power generation portion which is provided between the transparent electrode substrate and the counter substrate, and contains a dye, and a non-power generation portion provided to be adjacent to the power generation portion and to overlap with the display unit in the case of viewing the power generation portion and the display unit in the thickness direction of the substrate of the touch sensor.

According to the input device, in the case of viewing the power generation portion and the display unit in the thickness direction of the substrate of the touch sensor, the display unit is provided to be adjacent to the power generation portion of the photoelectric conversion cell and to overlap with the non-power generation portion. For this reason, when light is incident on the photoelectric conversion cell through the touch sensor, light is incident on the power generation portion other than the display unit without forming a portion which becomes a shadow by the display unit. That is, a portion on which light is incident, and a portion on which light is not incident are sufficiently prevented from being formed in the power generation portion. As a result, in the power generation portion, a bias in a generation amount of electrons is sufficiently prevented from being generated. As a result, deterioration of the dye is suppressed. Therefore, according to the invention, it is possible to improve durability of the photoelectric conversion cell, and also to improve durability of the input device.

In the input device described above, it is preferable that the display unit be included in a photoelectric conversion cell or a touch panel.

In the input device described above, it is preferable that the photoelectric conversion cell further include a ring-shaped sealing portion joining the transparent electrode substrate and the counter substrate together, the touch sensor include an electrode which is provided on the substrate, and is provided to overlap with the display unit in the case of viewing the touch sensor and the photoelectric conversion cell in the thickness direction of the substrate of the touch sensor, and a wiring connected to the electrode, and at least a part of the wiring be disposed to overlap with the ring-shaped sealing portion and to be along the ring-shaped sealing portion in the case of viewing the wiring and the ring-shaped sealing portion in the thickness direction of the substrate of the touch sensor.

In this case, since at least a part of the wiring is disposed to overlap with the ring-shaped sealing portion and to be along the ring-shaped sealing portion in the case of viewing the wiring and the ring-shaped sealing portion in the thickness direction of the substrate of the touch sensor, it is possible to decrease an area of the wiring blocking the incidence of light onto the power generation portion, and to increase an aperture ratio.

In the input device described above, it is preferable that in the touch sensor, the electrode be composed of a mesh wiring.

In this case, in a case where the electrode is provided to overlap with the power generation portion in the case of viewing the power generation portion and the electrode in the thickness direction of the substrate of the touch sensor, it is possible to increase an incidence amount of light onto the power generation portion, and to further improve photoelectric conversion characteristics of the photoelectric conversion cell.

In the input device described above, it is preferable that a difference in transmittance of visible light between a portion passing through the mesh wiring and a portion passing through a portion other than the mesh wiring is less than or equal to 10%.

In this case, since it is possible to further decrease a variation in a power generation amount of the power generation portion receiving light, compared to a case where a difference in transmittance of visible light between the portion passing through the mesh wiring and the portion passing through the portion other than the mesh wiring is greater than 10%, it is possible to further increase service life of the photoelectric conversion cell. For this reason, it is possible to further increase service life of the input device.

In the input device described above, it is preferable that the photoelectric conversion cell include an electrolyte between the transparent electrode substrate and the counter substrate, and the non-power generation portion include an insulating portion containing a coloring material, and a covering portion covering the insulating portion.

In this case, since in the non-power generation portion, the insulating portion is covered with the covering portion, it is more sufficiently prevented that the insulating portion containing the coloring material is in contact with the electrolyte and then the coloring material is dissolved in the electrolyte. Accordingly, it is possible to reduce the amount of coloring material entering the electrolyte. For this reason, according to the input device of the invention, it is possible to suppress deterioration in photoelectric conversion characteristics due to the mixing of the coloring material, and to more sufficiently improve the durability.

In the input device described above, it is preferable that the insulating portion contain an insulating material, and the insulating material contain an inorganic insulating material.

In this case, a dimensional change of the insulating portion further decreases, compared to a case where the insulating material does not contain the inorganic insulating material.

In the input device described above, it is preferable that the coloring material be composed of an oxide of a transition metal.

In this case, it is possible to more sufficiently prevent the coloring material from being dissolved in the electrolyte.

In the input device described above, it is preferable that a content ratio of the coloring material in the covering portion is less than a content ratio of the coloring material in the insulating portion.

In this case, the coloring material in the non-power generation portion is sufficiently prevented from being mixed into the electrolyte, compared to a case where the content ratio of the coloring material in the covering portion is greater than or equal to the content ratio of the coloring material in the insulating portion. For this reason, in the photoelectric conversion cell, it is possible to suppress deterioration in the photoelectric conversion characteristics due to the mixing of the coloring material, and to more sufficiently improve the durability.

In the input device described above, it is preferable that in a surface of the insulating portion excluding an interface between the insulating portion and the transparent electrode substrate from the surface, an area of a region in which the covering portion is not provided, be less than or equal to 10%.

In this case, even in a case where the coloring material in the insulating portion is dissolved into the electrolyte, it is possible to more sufficiently reduce an influence on the durability of the photoelectric conversion cell, compared to a case where the area of the region described above is greater than 10%.

In the input device described above, it is preferable that the non-power generation portion also functions as the display unit.

In this case, since it is not necessary to provide the display unit in the touch sensor by the non-power generation portion also functioning as the display unit, it is possible to further reduce the thickness of the touch sensor, and to further reduce the size of the input device.

In the input device described above, it is preferable that the photoelectric conversion cell include an electrolyte between the transparent electrode substrate and the counter substrate, and the touch sensor include the display unit.

In this case, in the input device, the non-power generation portion is not visible in the case of viewing the non-power generation portion and the display unit in the thickness direction of the substrate of the touch sensor, and thus, it is not necessary for the non-power generation portion to contain the coloring material. For this reason, the coloring material in the non-power generation portion is sufficiently prevented from being mixed into the electrolyte. For this reason, in the photoelectric conversion cell, it is possible to suppress deterioration in the photoelectric conversion characteristics due to the mixing of the coloring material, and to more sufficiently improve the durability.

In the input device described above, for example, the at least one photoelectric conversion cell is composed of a plurality of photoelectric conversion cells, and the plurality of photoelectric conversion cells are connected in series.

EFFECT OF THE INVENTION

According to the invention, an input device capable of improving durability is provided.

BRIEF DESCRIPTION OF DRAWINGS

Fig. 1 is a plan view illustrating one embodiment of an input device of the invention;
Fig. 2 is a sectional view schematically illustrating the input device of Fig. 1;
Fig. 3 is a plan view illustrating a part of the input device of Fig. 1;
Fig. 4 is a sectional view along line IV-IV of Fig. 3;
Fig. 5 is a sectional view illustrating a non-power generation portion of Fig. 4;
Fig. 6 is a plan view in the case of viewing a power generation portion and a non-power generation portion of a photoelectric conversion element of Fig. 2 from a touch sensor side;
Fig. 7 is a sectional view along line VII-VII of Fig. 6; and
Fig. 8 is a sectional end view illustrating main parts of another embodiment of an input device of the invention.

MODE(S) FOR CARRYING OUT THE INVENTION

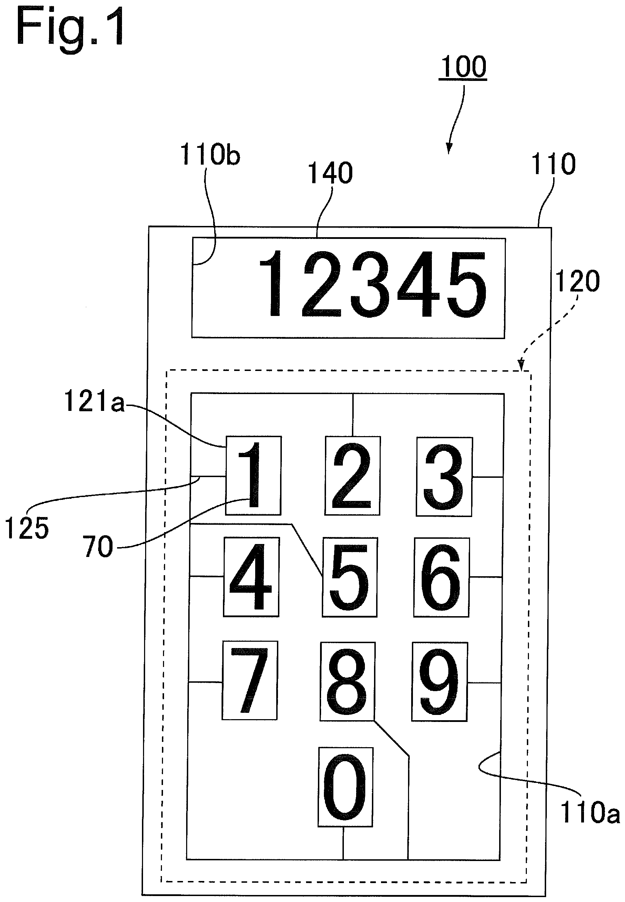

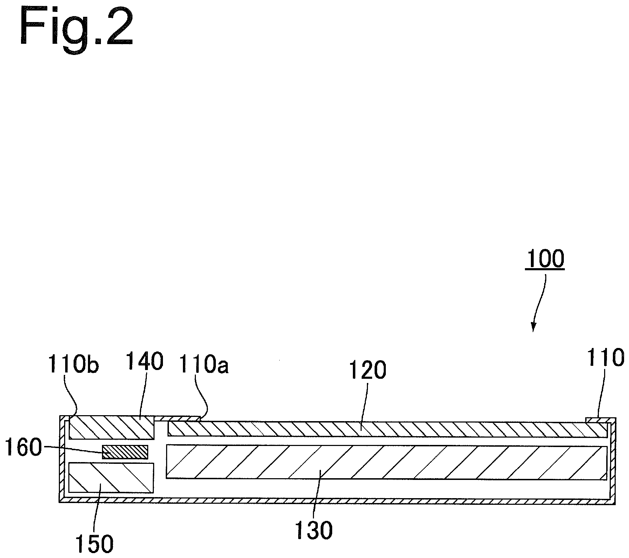

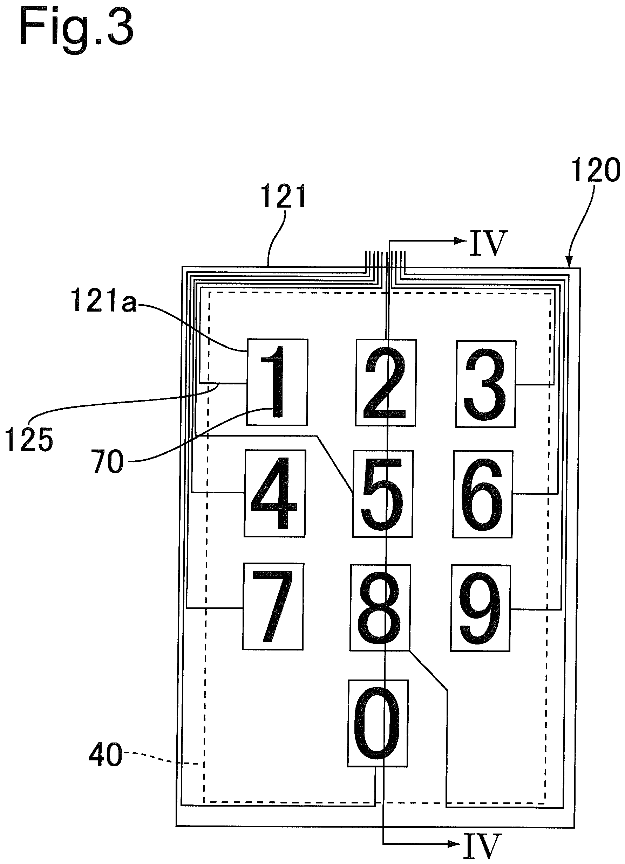

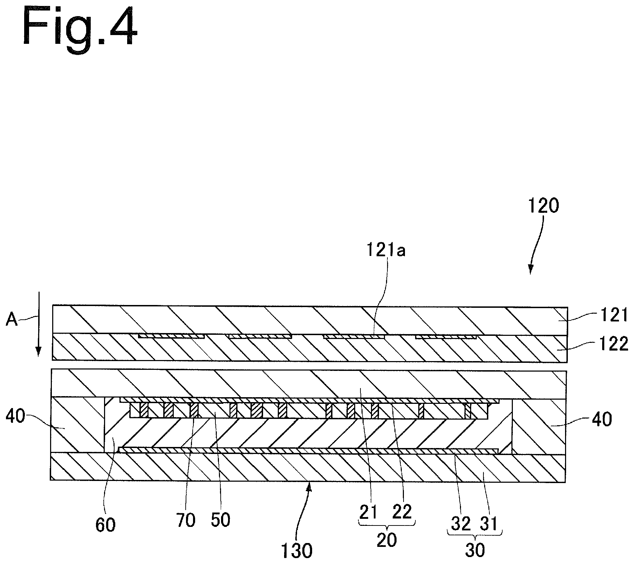

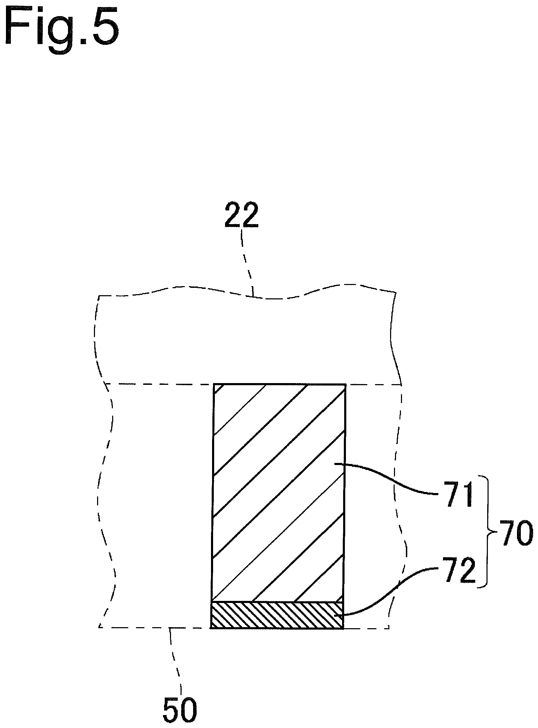

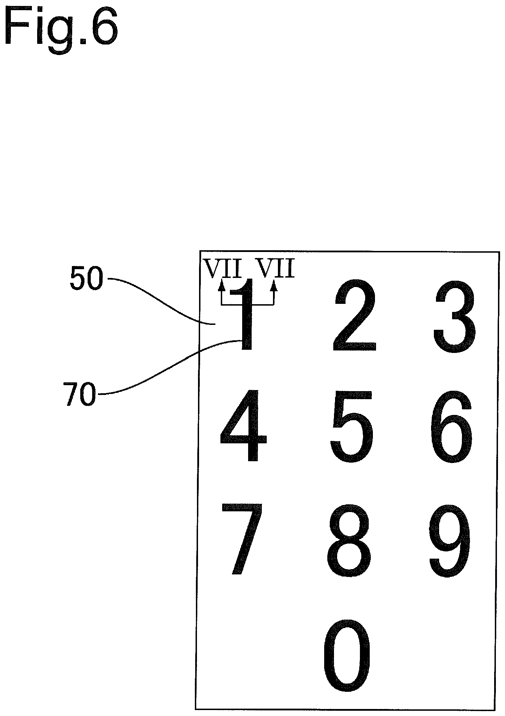

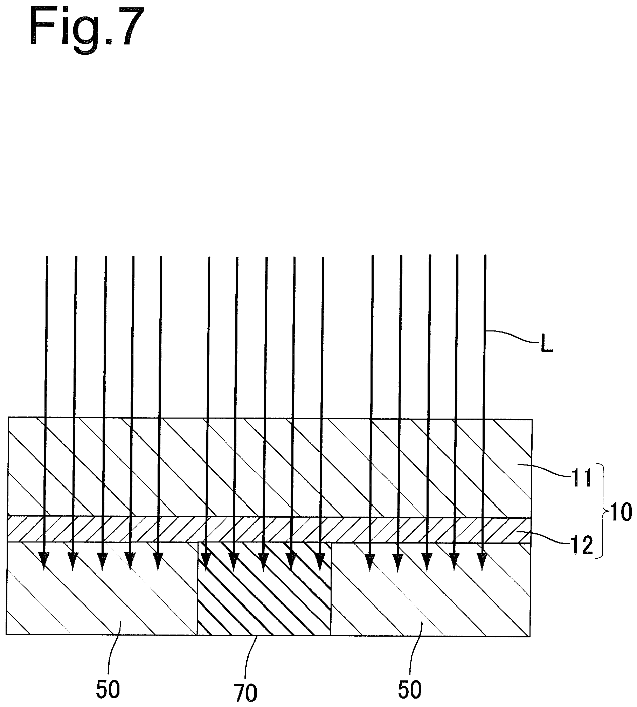

Hereinafter, an embodiment of an input device according to the invention will be described in detail, with reference to Fig. 1 to Fig. 7. Furthermore, Fig. 1 is a plan view illustrating a preferred embodiment of the input device of the invention, Fig. 2 is a sectional view schematically illustrating the input device of Fig. 1, Fig. 3 is a plan view illustrating a part of the input device of Fig. 1, Fig. 4 is a sectional view along line IV-IV of Fig. 3, Fig. 5 is a sectional view illustrating a non-power generation portion of Fig. 4, Fig. 6 is a plan view in the case of viewing a power generation portion and a non-power generation portion of a photoelectric conversion element of Fig. 2 from a touch sensor side, and Fig. 7 is a sectional view along line VII-VII of Fig. 6.

As illustrated in Fig. 1 and Fig. 2, an input device 100 includes a housing 110 provided with a first opening 110a and a second opening 110b. Inside the housing 110, there are provided a touch sensor 120 disposed to block the first opening 110a of the housing 110, one photoelectric conversion cell 130 disposed in a position facing the touch sensor 120, a liquid crystal display unit 140 disposed to block the second opening 110b of the housing 110, a storage cell 150 connected to the photoelectric conversion cell 130, and a control unit 160 which is electrically connected to the touch sensor 120, the photoelectric conversion cell 130, and the liquid crystal display unit 140, and allows the liquid crystal display unit 140 to display the corresponding numeric characters on the basis of the manipulation of the touch sensor 120.

As illustrated in Fig. 4 and Fig. 6, the photoelectric conversion cell 130 includes a transparent electrode substrate 20, a counter substrate 30 facing the transparent electrode substrate 20, a ring-shaped sealing portion 40 joining the transparent electrode substrate 20 and the counter substrate 30 together, a power generation portion 50 which is provided on the transparent electrode substrate 20, and contains a dye, a non-power generation portion 70 provided on the transparent electrode substrate 20 to be adjacent to the power generation portion 50, and an electrolyte 60 provided between the transparent electrode substrate 20 and the counter substrate 30. Here, the transparent electrode substrate 20 is provided on the touch sensor 120 side, and the counter substrate 30 is provided on a side facing away from the touch sensor 120, with respect to the transparent electrode substrate 20. In addition, the non-power generation portion 70 also functions as the display unit in this embodiment, and is provided to overlap with the display unit in the case of viewing the display unit and the non-power generation portion 70 in a thickness direction A of a substrate 121 of the touch sensor 120.

On the other hand, as illustrated in Fig. 3 and Fig. 4, the touch sensor 120 includes the substrate 121, an electrode 121a provided on the substrate 121, and a covering layer 122 provided on the substrate 121 to cover the electrode 121a. Here, in the touch sensor 120, the non-power generation portion 70 which also functions as the display unit of the photoelectric conversion cell 130, is visible in the case of viewing the touch sensor 120 in the thickness direction A of the substrate 121 of the touch sensor 120 (a direction orthogonal to a surface of the substrate 121 of the touch sensor 120). In Fig. 1 and Fig. 3, ten non-power generation portions 70 are illustrated, and constitute numeric characters of "0" to "9", respectively. Furthermore, the non-power generation portion 70 and the electrode 121a as the display unit are arranged to overlap with each other in the case of being seen in the thickness direction A of the substrate 121 of the touch sensor 120.

In addition, as illustrated in Fig. 1 and Fig. 3, in the touch sensor 120, a wiring 125 is connected to the electrode 121a. At least a part of the wiring 125 extends from the electrode 121a and is disposed to overlap with the ring-shaped sealing portion 40 and to be along the ring-shaped sealing portion 40 in the case of viewing the wiring 125 and the ring-shaped sealing portion 40 in the thickness direction A of the substrate 121 of the touch sensor 120. Then, an end portion of the wiring 125 is connected to the control unit 160 (refer to Fig. 2).

According to the input device 100, the non-power generation portion 70 which also functions as the display unit, is visible in the case of viewing the non-power generation portion 70 as the display unit in the thickness direction A of the substrate 121 of the touch sensor 120. That is, in the input device 100, the display unit is provided to be adjacent to the power generation portion 50 of the photoelectric conversion cell 130 and to overlap with the non-power generation portion 70. For this reason, as illustrated in Fig. 7, when light L is incident on the photoelectric conversion cell 130 through the touch sensor 120, light is incident on the power generation portion 50 without forming a portion which becomes a shadow by the display unit. That is, in the power generation portion 50, a portion on which light is incident, and a portion on which light is not incident, are sufficiently prevented from being formed. For this reason, in the power generation portion 50, a bias in a generation amount of electrons is sufficiently prevented from being generated. As a result, deterioration of a dye is suppressed. Accordingly, in the input device 100, durability of the photoelectric conversion cell 130 is improved, and durability of the input device 100 is also improved.

In addition, in the input device 100, the touch sensor 120 includes the wiring 125 connected to the electrode 121a, and at least a part of the wiring 125 is disposed to overlap with the ring-shaped sealing portion 40 and to be along the ring-shaped sealing portion 40 in the case of viewing the wiring 125 and the ring-shaped sealing portion 40 in the thickness direction A of the substrate 121 of the touch sensor 120.

For this reason, it is possible to decrease an area of the wiring 125 blocking the incidence of light onto the power generation portion 50, and to increase an aperture ratio.

Further, in the input device 100, the non-power generation portion 70 also functions as the display unit, and thus, it is not necessary to provide the display unit in the touch sensor 120. For this reason, it is possible to further reduce the thickness of the touch sensor 120, and to further reduce the size of the input device 100.

Next, the touch sensor 120 and the photoelectric conversion cell 130 will be described in detail.

<<Touch Sensor>>

As described above, the touch sensor 120 includes the substrate 121, the electrode 121a provided on the substrate 121, and the covering layer 122 provided on the substrate 121 to cover the electrode 121a.

(Substrate)

For example, a resin film such as a PET film and a PEN film, a substrate composed of an inorganic material such as glass, and the like can be used as the substrate 121.

(Electrode)

The electrode 121a is provided to overlap with the non-power generation portion 70 in the case of viewing the non-power generation portion 70 and the electrode 121a as the display unit in the thickness direction A of the substrate 121 of the touch sensor 120. It is preferable that the electrode 121a be composed of a mesh wiring. In this case, when the electrode 121a is provided to overlap with the power generation portion 50 in the case of viewing the power generation portion 50 and the electrode 121a in the thickness direction A of the substrate 121 of the touch sensor 120, it is possible to increase an incidence amount of light onto the power generation portion 50, and thus, it is possible to further improve photoelectric conversion characteristics of the photoelectric conversion cell 130. In a case where the electrode 121a is composed of the mesh wiring, an opaque metal material such as silver or copper, or a carbon material can be used as the electrode 121a. Here, in a case where light is incident in the thickness direction A of the substrate 121 of the touch sensor 120, it is preferable that a difference in transmittance of visible light between a portion passing through the mesh wiring and a portion passing through a portion other than the mesh wiring be less than or equal to 10%. In this case, it is possible to further decrease a variation in a power generation amount of the power generation portion 50 receiving light, and thus, it is possible to increase service life of the photoelectric conversion cell 130. For this reason, it is possible to increase service life of the input device 100. It is more preferable that the difference in the transmittance of the visible light be less than or equal to 5%. In a case where the electrode 121a is composed of the mesh wiring, a line width of the mesh wiring is not particularly limited, and for example, may be less than or equal to 100 $\mu$m. However, it is not necessary that the electrode 121a be composed of the mesh wiring. For example, the electrode 121a can be composed of a transparent metal material such as ITO or FTO.

(Covering layer)

The covering layer 122 may be constituted by a transparent material. Examples of such the transparent material include a transparent resin such as an epoxy resin, an acrylic resin, a polyester resin, a urethane resin, a vinyl resin, a silicone resin, a phenol resin or a polyimide resin.

The covering layer 122 can be obtained by covering the substrate 121 with the transparent resin using a printing method or the like.

<<Photoelectric conversion cell>>

Next, the photoelectric conversion cell 130 will be described in detail.

The photoelectric conversion cell 130 has a transparent electrode substrate 20, the counter substrate 30, the sealing portion 40, the power generation portion 50, the non-power generation portion 70 and the electrolyte 60. Hereinafter, these will be described in detail.

<Transparent electrode substrate>

The transparent electrode substrate 20 comprises a transparent substrate 21, and a transparent conductive layer 22 which is provided on a side of the transparent substrate 21 facing the counter substrate 30 and serves as an electrode.

(Transparent substrate)

The material constituting the transparent substrate 21 may be a transparent insulating material, for example, and examples of such a transparent material include glass such as borosilicate glass, soda lime glass, glass which is made of soda lime and whose iron component is less than that of ordinary soda lime glass, and quartz glass, polyethylene terephthalate (PET), polyethylene naphthalate (PEN), polycarbonate (PC), and polyethersulfone (PES). The thickness of the transparent substrate 21 is appropriately determined depending on the size of the photoelectric conversion cell 130 and is not particularly limited, but it may be set to the range of from 0.050 to 10 mm, for example.

(Transparent Conductive Layer)

Examples of the material constituting the transparent conductive layer 22 include a conductive metal oxide such as indium-tin-oxide (ITO), tin oxide ($SnO_2$), and fluorine-doped-tin-oxide (FTO). The transparent conductive layer 22 may be constituted by a single layer or a laminate consisting of a plurality of layers containing different conductive metal oxides. It is preferable that the transparent conductive layer 22 contain FTO since the FTO exhibits high heat resistance and chemical resistance in a case in which the transparent conductive layer 22 is constituted by a single layer. The thickness of the transparent conductive layer 22 may be set to the range of from 0.01 to 2 $\mu$m, for example.

(Counter Substrate)

The counter substrate 30, which is composed of a counter electrode in this embodiment, comprises the conductive substrate 31 and the catalyst layer 32 which is provided on a side of the conductive substrate 31 facing the transparent electrode substrate 20 and contributes to reduction of the electrolyte 60.

The conductive substrate 31 may be constituted by a corrosion-resistant metal material such as titanium, nickel, molybdenum, tungsten, aluminum, or stainless steel. Moreover, the conductive substrate 31 may be a laminate in which a conductive layer composed of a conductive oxide such as ITO or FTO is formed as an electrode on the transparent substrate 21 described above. The thickness of the conductive substrate 31 is appropriately determined depending on the size of the photoelectric conversion cell 130, and is not particularly limited, but may be set to 0.005 mm to 0.1 mm, for example.

The catalyst layer 32 is constituted by a conductive material. Examples of the conductive material include a metal material such as platinum, a carbon-based material and a conductive polymer. Here, a carbon nanotube is preferably used as the carbon-based material.

(Sealing portion)

Examples of the sealing portion 40 include a resin such as a thermoplastic resin including a modified polyolefin resin or a vinyl alcohol polymer, or an ultraviolet curable resin. Examples of the modified polyolefin resin include an ionomer, an ethylene-vinyl acetic anhydride copolymer, an ethylene-methacrylic acid copolymer and an ethylene-vinyl alcohol copolymer. These can be used singly or in a combination of two or more types of such resins.

<Power generation portion>

The power generation portion 50 includes an oxide semiconductor layer and a dye supported on the oxide semiconductor layer.

(Oxide Semiconductor Layer)

The oxide semiconductor layer is composed of oxide semiconductor particles. The oxide semiconductor particles are composed of, for example, titanium oxide ($TiO_2$) , zinc oxide (ZnO), tungsten oxide ($WO_3$), niobium oxide ($Nb_2O_5$), strontium titanate ($SrTiO_3$), tin oxide ($SnO_2$), indium oxide ($In_3O_3$), zirconium oxide ($ZrO_2$), tallium oxide ($Ta_2O_5$), lanthanum oxide ($La_2O_3$), yttrium oxide ($Y_2O_3$), holmium oxide ($Ho_2O_3$), bismuth oxide ($Bi_2O_3$), cerium oxide ($CeO_2$), aluminum oxide ($Al_2O_3$) or two or more kinds of these. The thickness of the oxide semiconductor layer 50 may be set to 0.1 $\mu$m to 100 $\mu$m, for example.

<Dye>

As the dye, for example, a photosensitizing dye such as a ruthenium complex having a ligand including a bipyridine structure or a terpyridine structure, an organic dye including porphyrin, eosin, rhodamine or merocyanine; or an organic-inorganic composite dye including a halogenated lead-based perovskite crystal are exemplified. As the halogenated lead-based perovskite, for example, $CH_3NH_3PbX_3$ (X = Cl, Br, I) is used. Among the above-mentioned dyes, a ruthenium complex having a ligand including a bipyridine structure or a terpyridine structure is preferable. In this case, it is possible to further improve the photoelectric conversion characteristics of the photoelectric conversion cell 130. Furthermore, in a case using a photosensitizing dye as the dye, the photoelectric conversion cell 130 becomes a dye-sensitized photoelectric conversion cell.

<Non-Power Generation Portion>

The non-power generation portion 70 may not have a photoelectric conversion function. However, in this embodiment, the non-power generation portion 70 also functions as the display unit, and thus, it is necessary that the non-power generation portion 70 can be viewed by being distinguished from the power generation portion 50 in the case of viewing the non-power generation portion 70 and the power generation portion 50 in the thickness direction A of the substrate 121 of the touch sensor 120. Specifically, as illustrated in Fig. 5, the non-power generation portion 70 is composed including an insulating portion 71 containing a coloring material. Here, the coloring material indicates a substance having an absorption peak in a wavelength range of visible light.

The insulating portion 71 contains an insulating material. For example, an inorganic insulating material such as glass frit, and an organic insulating material such as a thermosetting resin (a polyimide resin or the like) and a thermoplastic resin are exemplified as the insulating material. Among them, the inorganic insulating material such as glass frit is preferable as the insulating material. In this case, a dimensional change of the insulating portion 71 further decreases, compared to a case where the insulating material is not the inorganic insulating material.

The coloring material contained in the insulating portion 71 may be any coloring material as long as the coloring material colors the insulating portion 71, and examples of such the coloring material include, for example, an oxide of a transition metal, a carbon-based material, an organic dye, and the like. These can be used singly or in a combination of two or more types of such coloring materials. Among them, the oxide of the transition metal is preferable as the coloring material. In this case, it is possible to more sufficiently prevent the coloring material from being dissolved in the electrolyte 60.

For example, copper oxide, iron oxide, cobalt oxide, manganese oxide, and the like are exemplified as the oxide of the transition metal. These can be used singly or in a combination of two or more types of such oxides.

A content ratio of the coloring material in the insulating portion 71 is not particularly limited, but is preferably greater than or equal to 5 mass%. In this case, it is possible to further decrease light transmittivity, compared to a case where the content ratio of the coloring material in the insulating portion 71 is less than 5 mass%. The content ratio of the coloring material in the insulating portion 71 is more preferably greater than or equal to 7 mass%, and is particularly preferably greater than or equal to 9 mass%. However, it is preferable that the content ratio of the coloring material in the insulating portion 71 is less than or equal to 30 mass%. The coloring material can be more sufficiently prevented from being dissolved in the electrolyte 60, compared to a case where the content ratio of the coloring material in the insulating portion 71 is greater than 30 mass%. The content ratio of the coloring material in the insulating portion 71 is more preferably less than or equal to 27 mass%, and is particularly preferably less than or equal to 25 mass%.

Further, as illustrated in Fig. 5, it is preferable that the non-power generation portion 70 further includes a covering portion 72 covering the insulating portion 71, in addition to the insulating portion 71 containing the coloring material. In this case, in the non-power generation portion 70, the insulating portion 71 is covered with the covering portion 72, and thus, it is possible to sufficiently prevent the insulating portion 71 containing the coloring material from being in contact with the electrolyte 60 and being dissolved in the electrolyte 60. Accordingly, in the photoelectric conversion cell 130, it is possible to reduce the amount of coloring material entering the electrolyte 60. For this reason, according to the input device 100, it is possible to suppress a deterioration in the photoelectric conversion characteristics due to the mixing of the coloring material, and to more sufficiently improve the durability. In particular, the covering portion 72 is effective in a case where the total area of the non-power generation portion 70 within a region surrounded by the sealing portion 40 (within a region surrounded by a broken line of Fig. 3) is greater than or equal to 10%.

(Covering Portion)

The covering portion 72 is composed of an insulating material. The same insulating material as that constituting the insulating portion 71 can be used as the insulating material. The insulating material constituting the covering portion 72 may be identical to or different from the insulating material constituting the insulating portion 71.

A content ratio of the coloring material in the covering portion 72 may be less than the content ratio of the coloring material in the insulating portion 71, or may be greater than or equal to the content ratio of the coloring material in the insulating portion 71, but it is preferable that the content ratio of the coloring material in the covering portion 72 be less than the content ratio of the coloring material in the insulating portion 71. In this case, the coloring material in the non-power generation portion 70 is more sufficiently prevented from being mixed into the electrolyte 60, compared to a case where the content ratio of the coloring material in the covering portion 72 is greater than or equal to the content ratio of the coloring material in the insulating portion 71. For this reason, in the photoelectric conversion cell 130, it is possible to suppress deterioration in the photoelectric conversion characteristics due to the mixing of the coloring material, and to more sufficiently improve the durability. Here, the content ratio of the coloring material in the covering portion 72 may be 0 mass%. That is, the covering portion 72 may not contain the coloring material. In addition, the content ratio of the coloring material in the covering portion 72 may be greater than 0 mass% as long as the content ratio is less than the content ratio in the insulating portion 71. That is, in a case where the content ratio of the coloring material in the covering portion 72 is the content ratio less than the content ratio in the insulating portion 71, the covering portion 72 may contain the coloring material.

In this case, the coloring material in the covering portion 72 typically means the same coloring material as the coloring material contained in the insulating portion 71. For example, the coloring material in the covering portion 72 is also the oxide of the transition metal, if the coloring material contained in the insulating portion 71 is the oxide of the transition metal.

The thickness of the covering portion 72 from a surface of the insulating portion 71 is typically 3 $\mu$m to 20 $\mu$m, and is preferably 5 $\mu$m to 10 $\mu$m.

Furthermore, it is preferable that in the surface of the insulating portion 71 excluding an interface between the insulating portion 71 and the transparent electrode substrate 20 from the surface, an area of a region in which the covering portion 72 is not provided, be less than or equal to 10%. In this case, even in a case where the coloring material in the insulating portion 71 is dissolved into the electrolyte 60, it is possible to more sufficiently reduce an influence on the durability of the photoelectric conversion cell 130, compared to a case where the area of the region described above is greater than 10%. The area of the region described above is more preferably less than or equal to 8%, and is particularly preferably less than or equal to 6%.

(Electrolyte)

The electrolyte 60 contains a redox couple and an organic solvent. It is possible to use acetonitrile, methoxy acetonitrile, methoxy propionitrile, propionitrile, ethylene carbonate, propylene carbonate, diethyl carbonate, $\gamma$-butyrolactone, valeronitrile, or pivalonitrile as the organic solvent. Examples of the redox couple include a redox couple such as a zinc complex, an iron complex, and a cobalt complex in addition to a redox couple containing a halogen atom such as iodide ion/polyiodide ion (for example, $I^-/I_3^-$) or bromide ion/polybromide ion. Incidentally, iodide ion/polyiodide ion can be formed by iodine ($I_2$) and a salt (ionic liquid or a solid salt) containing an iodide ($I^-$) as an anion. In a case of using ionic liquid having an iodide as an anion, only iodine may be added. In a case of using an organic solvent, or ionic liquid other than iodide as an anion, a salt containing iodide ($I^-$) as an anion, such as LiI or tetrabutylammonium iodide may be added. In addition, the electrolyte 60 may use ionic liquid instead of the organic solvent. As the ionic liquid, for example, a known iodine salt, such as a pyridinium salt, an imidazolium salt, or a triazolium salt is used. As such an iodine salt, for example, 1-hexyl-3-methylimidazolium iodide, 1-ethyl-3-propylimidazolium iodide, 1-ethyl-3-methylimidazolium iodide, 1,2-dimethyl-3-propylimidazolium iodide, 1-butyl-3-methylimidazolium iodide, or 1-methyl-3-propylimidazolium iodide is preferably used.

In addition, the electrolyte 60 may use a mixture of the above-mentioned ionic liquid and the above-mentioned organic solvent instead of the above-mentioned organic solvent.

In addition, it is possible to add an additive to the electrolyte 60. Examples of the additive include benzimidazole such as 1-methylbenzimidazole (NMB) or 1-butylbenzimidazole (NBB), LiI, tetrabutylammonium iodide, 4-t-butylpyridine and guanidium thiocyanate. Among them, benzimidazole is preferable as the additive.

Moreover, as the electrolyte 60, a nanocomposite gel electrolyte which is a quasi-solid electrolyte obtained by kneading nanoparticles such as $SiO_2$, $TiO_2$ and carbon nanotubes with the above-mentioned electrolyte to form a gel-like form may be used, or an electrolyte gelled using an organic gelling agent such as polyvinylidene fluoride, a polyethylene oxide derivative and an amino acid derivative may also be used.

The invention is not limited to the embodiment described above. For example, in the embodiment described above, the non-power generation portion 70 is composed by including the insulating portion 71 containing the coloring material, but the non-power generation portion 70 is not necessarily limited to a non-power generation portion which is composed including the insulating portion 71 containing the coloring material. For example, the non-power generation portion 70 may be composed of a mere space as long as the non-power generation portion 70 can be viewed by being distinguished from the power generation portion 50 in the case of viewing the non-power generation portion 70 and the power generation portion 50 in the thickness direction A of the substrate 121 of the touch sensor 120. In addition, if a light reflection layer is provided on the counter substrate 30 side, with respect to the power generation portion 50, and the light reflection layer can be viewed by being distinguished from the power generation layer 50, a portion of the light reflection layer, which can be viewed through the space in the case of viewing the non-power generation portion 70 in the thickness direction A of the substrate 121 of the touch sensor 120, is the non-power generation portion 70.

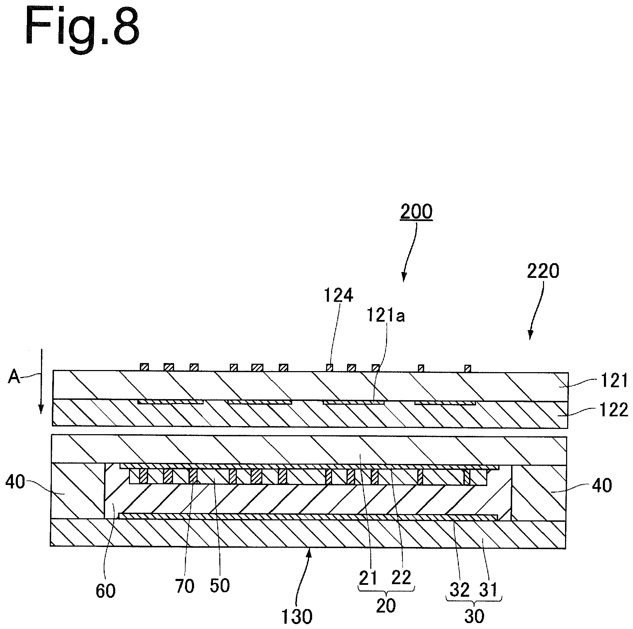

In addition, in the embodiment described above, the non-power generation portion 70 of the photoelectric conversion cell 130 also functions as the display unit, and the touch sensor 120 does not include the display unit, but like an input device 200 illustrated in Fig. 8, a touch sensor 220 may include a display unit 124. In this case, when light is incident on the photoelectric conversion cell 130 through the touch sensor 220, a portion which becomes a shadow by the display unit 124, is formed in the non-power generation portion 70, but light is incident on the power generation portion 50 without forming a portion which becomes a shadow by the display unit 124. That is, in the power generation portion 50, the portion on which light is incident, and the portion on which light is not incident are sufficiently prevented from being formed. For this reason, in the power generation portion 50, a bias in the generation amount of the electrons is sufficiently prevented from being generated. As a result, the deterioration of the dye is suppressed. Accordingly, even in the input device 200 illustrated in Fig. 8, the durability of the photoelectric conversion cell 130 is improved, and the durability of the input device 200 is also improved. In addition, in the input device 200 illustrated in Fig. 8, the non-power generation portion 70 is not visible in the case of viewing the non-power generation portion 70 and the display unit 124 in the thickness direction A of the substrate 121 of the touch sensor 220, and thus, it is not necessary that the non-power generation portion 70 contain the coloring material. For this reason, the coloring material in the non-power generation portion 70 is sufficiently prevented from being mixed into the electrolyte 60. For this reason, in the photoelectric conversion cell 130, it is possible to suppress deterioration in the photoelectric conversion characteristics due to the mixing of the coloring material, and to more sufficiently improve the durability. Here, it is preferable that the display unit 124 be disposed on the inside of an outline forming the non-power generation portion 70 in the case of viewing the display unit 124 and the non-power generation portion 70 in the thickness direction A of the substrate 121 of the touch sensor 220.

Further, in the embodiment described above, at least a part of the wiring 125 is disposed to overlap with the ring-shaped sealing portion 40 and to be along the ring-shaped sealing portion 40 in the case of viewing the wiring 125 and the ring-shaped sealing portion 40 in the thickness direction A of the substrate 121 of the touch sensor 120, but the wiring 125 may not be necessarily disposed to overlap with the ring-shaped sealing portion 40 and to be along the ring-shaped sealing portion 40.

In addition, in the embodiment described above, the non-power generation portion 70 also functions as the display unit, and the display units constitute the numeric characters of "0" to "9", respectively, but the display unit is not limited to the numeric character, and may be information such as characters, diagrams, symbols, or a combination thereof.

In addition, in the embodiment described above, the oxide semiconductor layer 50 is provided on the transparent electrode substrate 20 in the photoelectric conversion cell 130, but the oxide semiconductor layer 50 may be provided on the counter substrate 30. In this case, a catalytic layer 32 is provided on the transparent electrode substrate 20.

Further, in the embodiment described above, the counter substrate 30 is composed of a counter electrode, and the transparent electrode substrate 20 and the counter substrate 30 are linked by the sealing portion 40, but in a case where a porous insulating layer impregnated with the electrolyte 60 and an electrode layer are sequentially laminated on the oxide semiconductor layer 50 between the transparent electrode substrate 20 and the counter substrate 30, the counter substrate 30 may be composed of an insulating base material instead of the counter electrode.

In addition, in the embodiment described above, the input device 100 includes the housing 110, the liquid crystal display unit 140, the storage battery 150, and the control unit 160, but these are not necessarily required, and can be omitted.

In addition, in the embodiment described above, the input device 100 includes one photoelectric conversion cell 130, but the input device 100 may include a plurality of photoelectric conversion cells 130. Here, the plurality of photoelectric conversion cells 130 may be connected in series, or may be connected in parallel.

Examples

Hereinafter, the contents of the invention will be described more specifically by using examples, but the invention is not limited to the following examples.

(Example 1)

First, a laminated body was prepared in which a transparent conductive layer formed of FTO and having a thickness of 1 μm was formed on a transparent substrate formed of glass and having a thickness of 1 mm.

Next, a paste for forming an insulating portion containing glass frit and a coloring material was applied onto the transparent conductive layer by screen printing to form a character of "2", and was dried, and thus, a precursor of an insulating portion was formed. At this time, in the paste for forming an insulating portion, the coloring material was contained such that a content ratio of the coloring material in the glass frit was 15 mass%. A coloring material formed of iron oxide, copper oxide, and manganese oxide was used as the coloring material.

Subsequently, a precursor of a covering portion was formed to cover the entire precursor of the insulating portion. The precursor of the covering portion was formed by applying and drying a paste for forming a covering portion formed of glass frit. At this time, a content ratio of a coloring material in the paste for forming a covering portion was 0 mass%.

Further, a precursor of an oxide semiconductor layer constituting a power generation portion was formed on the transparent conductive layer. However, at this time, the precursor of the covering portion was not covered. The precursor of the oxide semiconductor layer was formed by applying a paste for forming an oxide semiconductor layer containing titania particles by screen printing and drying the paste.

Next, the precursor of the insulating portion, the precursor of the covering portion, and the precursor of the oxide semiconductor layer were fired at 500°C for 1 hour. Thus, an electrode structure including a non-power generation portion formed of the insulating portion and the covering portion, and the oxide semiconductor layer constituting the power generation portion, was obtained.

Next, the electrode structure described above was dipped in a dye solution, in which 0.2 mM of a photosensitized dye formed of N719 was contained, and a solvent was a mixed solvent obtained by mixing acetonitrile and tertbutanol at a volume ratio of 1 : 1, for a full day and night, and then, was taken out and dried, and thus, the photosensitized dye was supported on the oxide semiconductor layer.

Next, an electrolyte formed of 2 M of 1-hexyl-3-methyl imidazolium iodide, 0.002 M of $I_2$, 0.3 M of n-methyl benzimidazole, and 0.1 M of guanidium thiocyanate in a solvent formed of 3-methoxy propionitrile was dropped on the oxide semiconductor layer, and then dried, and thus, the electrolyte was disposed.

Next, a sealing portion forming body for forming a sealing portion was prepared. The sealing portion forming body was obtained by preparing one resin film for sealing formed of maleic anhydride-modified polyethylene (Product Name: Bynel, manufactured by DuPont), and by forming one quadrangular opening on the resin film for sealing. At this time, the sealing portion forming body was produced such that the opening had a dimension of 4.2 cm × 9.7 cm × 60 $\mu$m and the width of the sealing portion forming body was 1.8 mm.

Then, the sealing portion forming body was overlapped with the electrode structure described above, and then, the sealing portion forming body was heated and melted, and thus, was adhered onto the electrode structure described above.

Next, one counter substrate was prepared. One counter substrate was prepared by forming a catalytic layer formed of platinum, on a titanium foil of 4.6 cm × 10.0 cm × 40 $\mu$m, by a sputtering method.

Then, the sealing portion forming body adhered onto the electrode structure described above and the counter substrate were overlapped to face each other. Then, in such a state, the sealing portion forming body was heated and melted while being pressurized. Thus, the sealing portion was formed between the electrode structure and the counter substrate.

Thus, a photoelectric conversion cell was produced.

On the other hand, a touch sensor was prepared as described below. That is, first, a substrate formed of a PET film was prepared, and an electrode was formed in a region of 42 mm × 97 mm on a surface of the substrate by screen printing. At this time, the electrode was formed such that a mesh wiring has a line width of 4 $\mu$m and a difference in transmittance of visible light between a portion passing through the mesh wiring and a portion passing through a portion other than the mesh wiring was 10%. In addition, from the electrode, a wiring was formed such that a line width was 10 $\mu$m. At this time, the wiring extended to a region of 0.3 mm from an edge portion of the substrate, and was formed to be disposed along the region from there.

Then, the substrate described above was covered with the covering layer formed of a PET film to cover the electrode. Thus, the touch sensor was obtained.

Then, the photoelectric conversion cell and the touch sensor obtained as described above were laminated on each other. At this time, the photoelectric conversion cell and the touch sensor were fixed to each other by allowing the circumferences to adhere to each other with an adhesive agent. In addition, at this time, the non-power generation portion was overlapped with the electrode of the touch sensor in the case of viewing the non-power generation portion in the thickness direction of the substrate of the touch sensor. Thus, an input device was produced.

(Comparative Example 1)

An input device was produced by the same method as that of Example 1, except that a precursor of an insulating portion containing glass frit and a coloring material was not formed on a transparent conductive layer, and a precursor of a covering portion was not formed to cover the entire precursor of the insulating portion, and thus, a non-power generation portion was not formed.

<Evaluation of Durability>

In the photoelectric conversion cells of the input devices obtained in Example 1 and Comparative Example 1, initial output ($\eta_0$) was measured. Subsequently, light was incident on the photoelectric conversion cells for 1000 hours, by using a light source of a white LED, and then, output ($\eta$) was measured. Then, a retention rate of the output (an output retention rate) was calculated on the basis of the following Expression:

$$\text{Retention Rate of Output (\%)} = \eta/\eta_0 \times 100.$$

Results are shown in Table 1.

[Table 1]

| | Presence or Absence of Non-Power Generation Portion | Durability |
|---|---|---|
| | | Output Retention Rate (%) |
| Example 1 | Present | 99 |
| Comparative Example 1 | Absent | 77 |

As shown in Table 1, it was found that the photoelectric conversion cell of Example 1 had a high output retention rate, compared to the photoelectric conversion cell of Comparative Example 1.

As described above, according to the invention, it was confirmed that it was possible to improve the durability of the photoelectric conversion cell, and to improve the durability of the input device.

EXPLANATIONS OF LETTERS OR NUMERALS

| 20 | transparent electrode substrate |
|----|-------------------------------|
| 30 | counter substrate |
| 40 | sealing portion |
| 50 | power generation portion |
| 60 | electrolyte |
| 70 | non-power generation portion |
| 71 | insulating portion |
| 72 | covering portion |
| 100, 200 | input device |
| 120, 220 | touch sensor |
| 121 | substrate |
| 121a | electrode |
| 124 | display unit |
| 125 | wiring |
| 130 | photoelectric conversion cell |

**Claims**

1. An input device, comprising:

   at least one photoelectric conversion cell; and
   a touch sensor which faces the at least one photoelectric conversion cell, and includes a substrate,
   a display unit being visible in the case of viewing the touch sensor and the photoelectric conversion cell in a thickness direction of the substrate of the touch sensor,
   wherein the photoelectric conversion cell includes,
   a transparent electrode substrate provided on the touch sensor side,
   a counter substrate which is provided on a side facing away from the touch sensor, with respect to the transparent electrode substrate, and faces the transparent electrode substrate,
   a power generation portion which is provided between the transparent electrode substrate and the counter substrate, and contains a dye, and
   a non-power generation portion disposed to be adjacent to the power generation portion and to overlap with the display unit in the case of viewing the power generation portion and the display unit in the thickness direction of the substrate of the touch sensor.

2. The input device according to claim 1,
   wherein the photoelectric conversion cell further includes a ring-shaped sealing portion joining the transparent electrode substrate and the counter substrate together,
   the touch sensor includes,
   an electrode which is provided on the substrate, and is provided to overlap with the display unit in the case of viewing the touch sensor and the photoelectric conversion cell in the thickness direction of the substrate of the touch sensor, and
   a wiring connected to the electrode, and
   at least a part of the wiring is disposed to overlap with the ring-shaped sealing portion and to be along the ring-shaped sealing portion in the case of viewing the wiring and the ring-shaped sealing portion in the thickness direction of the substrate of the touch sensor.

3. The input device according to claim 2,
   wherein in the touch sensor, the electrode is composed of a mesh wiring.

**4.** The input device according to claim 3,
wherein a difference in transmittance of visible light between a portion passing through the mesh wiring and a portion passing through a portion other than the mesh wiring is less than or equal to 10%.

**5.** The input device according to any one of claims 1 to 4,
wherein the photoelectric conversion cell includes an electrolyte between the transparent electrode substrate and the counter substrate, and
the non-power generation portion includes an insulating portion containing a coloring material, and a covering portion covering the insulating portion.

**6.** The input device according to claim 5,
wherein the insulating portion contains an insulating material, and the insulating material contains an inorganic insulating material.

**7.** The input device according to claim 5 or 6,
wherein the coloring material is composed of an oxide of a transition metal.

**8.** The input device according to any one of claims 5 to 7,
wherein a content ratio of the coloring material in the covering portion is less than a content ratio of the coloring material in the insulating portion.

**9.** The input device according to any one of claims 5 to 8,
wherein in a surface of the insulating portion excluding an interface between the insulating portion and the transparent electrode substrate from the surface, an area of a region in which the covering portion is not provided, is less than or equal to 10%.

**10.** The input device according to any one of claims 1 to 9,
wherein the non-power generation portion also functions as the display unit.

**11.** The input device according to any one of claims 1 to 4,
wherein the photoelectric conversion cell includes an electrolyte between the transparent electrode substrate and the counter substrate, and
the touch sensor includes the display unit.

**12.** The input device according to any one of claims 1 to 11,
wherein the at least one photoelectric conversion cell is composed of a plurality of photoelectric conversion cells, and the plurality of photoelectric conversion cells are connected in series.

# Fig.1

# Fig.2

# Fig.3

# Fig.4

# Fig.5

# Fig.6

# Fig.7

# Fig.8

## INTERNATIONAL SEARCH REPORT

| International application No. |
| --- |
| PCT/JP2017/006836 |

**A. CLASSIFICATION OF SUBJECT MATTER**
*G06F3/02*(2006.01)i, *H01G9/20*(2006.01)i

According to International Patent Classification (IPC) or to both national classification and IPC

**B. FIELDS SEARCHED**

Minimum documentation searched (classification system followed by classification symbols)
G06F3/02, H01G9/20

Documentation searched other than minimum documentation to the extent that such documents are included in the fields searched

| Jitsuyo Shinan Koho | 1922–1996 | Jitsuyo Shinan Toroku Koho | 1996–2017 |
| Kokai Jitsuyo Shinan Koho | 1971–2017 | Toroku Jitsuyo Shinan Koho | 1994–2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2013-089527 A (Rohm Co., Ltd.), 13 May 2013 (13.05.2013), entire text; all drawings (Family: none) | 1-12 |
| A | US 2011/0298718 A1 (AU OPTRONICS CORP.), 08 December 2011 (08.12.2011), entire text; all drawings & TW 201145078 A | 1-12 |

☒ Further documents are listed in the continuation of Box C.   ☐ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 26 April 2017 (26.04.17) | 16 May 2017 (16.05.17) |

| Name and mailing address of the ISA/ Japan Patent Office 3-4-3,Kasumigaseki,Chiyoda-ku, Tokyo 100-8915,Japan | Authorized officer |
| --- | --- |
| | Telephone No. |

Form PCT/ISA/210 (second sheet) (January 2015)

**INTERNATIONAL SEARCH REPORT**

| International application No. |
| --- |
| PCT/JP2017/006836 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | Microfilm of the specification and drawings annexed to the request of Japanese Utility Model Application No. 18230/1986(Laid-open No. 134155/1987) (Omron Tateisi Electronics Co.), 24 August 1987 (24.08.1987), entire text; all drawings (Family: none) | 1-12 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013089527 A